# EUROPÄISCHE PATENTSCHRIFT

(11) **EP 3 865 829 B1**
(45) Veröffentlichungstag und Bekanntmachung des Hinweises auf die Patenterteilung: **14.08.2024**
(21) Anmeldenummer: 20216283.0
(22) Anmeldetag: 22.12.2020
(51) Int. Cl.: G01D 11/24, G01R 33/00, B29C 65/00, H01R 13/66, H01R 13/502

(54) **MAGNETFELDSENSOR MIT EINEM GERÄTEGEHÄUSE**
MAGNETIC FIELD SENSOR WITH A DEVICE HOUSING
CAPTEUR DE CHAMP MAGNÉTIQUE DOTÉ D'UN BOÎTIER D'APPAREIL

(30) Priorität: 17.02.2020 DE 102020201959
(43) Veröffentlichungstag der Anmeldung: 18.08.2021
(73) Patentinhaber: Continental Automotive Technologies GmbH, 30175 Hannover (DE)
(72) Erfinder: Wahler, Torsten, 65824 Schwalbach a. Ts. (DE); Hug, Klaus, 65824 Schwalbach a. Ts. (DE); Frosch, Karl, 65824 Schwalbach a. Ts. (DE)
(74) Vertreter: Continental Corporation

(56) Entgegenhaltungen:
- EP-A1- 3 441 778
- EP-A1- 3 557 552
- DE-U1- 29 716 262
- GB-A- 2 352 443
- US-A1- 2003 189 047
- US-A1- 2019 012 892

## Beschreibung

Die Erfindung bezieht sich auf einen Magnetfeldsensor mit einem zumindest ein erstes Gehäuseteil und ein das erste Gehäuseteil verschließendes zweites Gehäuseteil aufweisenden Gerätegehäuse, wobei das erste Gehäuseteil und das zweite Gehäuseteil in Richtung einer Längsachse des Gerätegehäuses gefügt und mittels einer nicht-lösbaren Fügeverbindung verbunden sind.

Ein solcher Magnetfeldsensor ist zum Beispiel als sogenannter Geschwindigkeitsgeber oder Drehwertgeber für einen Fahrtschreiber in einem Kraftfahrzeug, insbesondere Nutzfahrzeug, bekannt. Der Magnetfeldsensor weist einen Sensorkopf auf und wird zum Beispiel in ein Getriebegehäuse eines Getriebes des Kraftfahrzeugs beispielsweise eingeschraubt oder zum Beispiel in der Nähe eines sich korrespondierend mit einer Fahrgeschwindigkeit des Kraftfahrzeugs drehenden Drehbauteils befestigt. Mittels des Sensorkopfes erfasst der Magnetfeldsensor eine Bewegung eines Getriebezahnrades des Getriebes bzw. des Drehbauteils. Die Bewegung des Getriebezahnrades ist ein Maß für die Geschwindigkeit des Kraftfahrzeugs. Ein Teil eines ersten Gehäuseteils eines Gerätegehäuses des Magnetfeldsensors ist Bestandteil des Sensorkopfes. Das erste Gehäuseteil wird von einem zweiten Gehäuseteil des Gerätegehäuses verschlossen, wobei das zweite Gehäuseteil Anschlusskontakte aufweist, mittels welchen der Magnetfeldsensor mit dem Fahrtschreiber des Kraftfahrzeugs verbunden wird. Zum Schutz von in dem Gerätegehäuse angeordneten Bauteilen des Magnetfeldsensors sowohl vor Umwelteinflüssen als auch vor unerlaubten äußeren Zugriffen sind das erste Gehäuseteil und das zweite Gehäuseteil mittels einer nicht-lösbaren Fügeverbindung verbunden. Aufgrund der erforderlichen hohen Zuverlässigkeit von mit dem Fahrtschreiber aufgezeichneten Daten ist es unter anderem von Bedeutung, eine Manipulation des Magnetfeldsensors und aus einer solchen Manipulation folgende Datenverfälschungen zu vermeiden.

Ein Magnetfeldsensor, der einen Mikroprozessor und eine Anzeige aufweist, ist aus US 2019/012892 A1 bekannt. Der Magnetfeldsensor kann zudem eine Leiterplatte und ein mit einem Deckel versehenes Gehäuse mit einer Öffnung umfassen. Auf der Leiterplatte kann eine Stromquelle in Form einer Knopfzellenbatterie montiert sein.

Aus DE 297 16 262 U1 ist eine Kunststoffdose mit einem Unterteil und einem Oberteil bekannt, wobei das Unter- und das Oberteil nicht-lösbar miteinander verbindbar sind. Das Unter- und das Oberteil sind jeweils mittels eines Spritzgießverfahrens hergestellt. Das Ober- und das Unterteil können mittels einer Schweißverbindung verbunden sein.

Eine Sicherheitsvorrichtungsanordnung, die eine Montagehalterung sowie eine in der Montagehalterung sitzende und um eine Ausrichtungsachse drehbare

Sicherheitsvorrichtung umfasst, offenbart EP 3 557 552 A1. Die Sicherheitsvorrichtung kann ein abnehmbar mit der Montagehalterung verbindbares Gehäuse enthalten.

Ferner ist aus EP 3 441 778 A1 ein Magnetfeldsensor mit einem ein Sensorelementgehäuseteil und ein Anschlusselementgehäuseteil aufweisenden Gerätegehäuse bekannt. Eine Gerätegehäuseaußenseite des Gerätegehäuses weist einen eine Verzahnung des Anschlusselementgehäuseteils mit dem Sensorelementgehäuseteil aufweisenden Verzahnungsbereich auf.

Aufgabe der Erfindung ist es, einen Magnetfeldsensor der eingangs genannten Art zu schaffen, der eine hohe Manipulationssicherheit aufweist.

Diese Aufgabe wird erfindungsgemäß durch einen Magnetfeldsensor gemäß Anspruch 1 gelöst. Besagte Aufgabe wird insbesondere dadurch gelöst, dass das erste Gehäuseteil und das zweite Gehäuseteil jeweils eine korrespondierende Wellenkontur aufweisen, wobei die Wellenkonturen in Richtung der Längsachse des Gerätegehäuses und an einem Gehäuserand des ersten Gehäuseteils bzw. an einem Gehäuserand des zweiten Gehäuseteils ausgebildet sind und in der Fügeverbindung eine Fügewellenkontur bilden.

Somit sind die Wellenkonturen in Fügerichtung, welche sich daraus ergibt, dass das erste Gehäuseteil und das zweite Gehäuseteil in Richtung der Längsachse des Gerätegehäuses gefügt sind, ausgebildet. Die Wellenkontur an dem ersten Gehäuseteil und die Wellenkontur an dem zweiten Gehäuseteil ergeben in der Fügeverbindung die Fügewellenkontur. Somit weist die Fügeverbindung die Fügewellenkontur auf. Die Fügewellenkontur läuft um das Gerätegehäuse des Magnetfeldsensors um, und zwar an einer Außenseite des Gerätegehäuses. Die Wellenkontur an dem ersten Gehäuseteil und die Wellenkontur an dem zweiten Gehäuseteil bilden jeweils eine Kronenstruktur an dem jeweiligen Gehäuseteil. Entsprechend bildet auch die Fügewellenkontur eine Kronenstruktur. Zum Beispiel ein Aufsägen des Gerätegehäuses beispielsweise mit einem dünnen Sägeschnitt ist somit nicht möglich, ohne dauerhaft sichtbare Veränderungen am Gerätegehäuse zurückzulassen.

Vorzugsweise können das erste Gehäuseteil und/oder das zweite Gehäuseteil jeweils ein Kunststoffbauteil sein, das heißt aus einem Kunststoffmaterial bestehen. Vorzugsweise kann das Kunststoffmaterial Glasfasern aufweisen, zum Beispiel einen Anteil von 30 %.

Von besonderem Vorteil ist bei dem erfindungsgemäßen Magnetfeldsensor das Vorsehen der korrespondierenden Wellenkonturen an dem Gehäuserand des ersten Gehäuseteils und an dem Gehäuserand des zweiten Gehäuseteils. Die sich daraus ergebende Fügewellenkontur in der Fügeverbindung hat zur Folge, dass ein unzulässiges Trennen von erstem Gehäuseteil und zweitem Gehäuseteil, welches Trennen zum Beispiel in manipulativer Absicht vorgenommen werden könnte, um an das Innere des Magnetfeldsensors zu gelangen, somit besonders zuverlässig erkennbar gemacht werden kann, da das Trennen nicht nur zu einem Öffnen des Gerätegehäuses, sondern auch zu einer Zerstörung der Fügewellenkontur und Bildung einer von der Fügewellenkontur abweichenden Trennlinie führt. Bei einem erneuten Fügen und Verbinden von erstem Gehäuseteil und zweitem Gehäuseteil bleibt mithin eine von der Fügewellenkontur abweichende Trennlinie sichtbar, wodurch die erfolgte Manipulation dauerhaft erkennbar bleibt.

Man könnte sich zum Beispiel vorstellen, dass die Fügeverbindung eine Klebeverbindung ist. Hingegen ist es für eine besonders zuverlässige, dauerhaltbare und insbesondere auch in einer Großserienfertigung gut herstellbare Fügeverbindung von Vorteil, wenn gemäß einer Weiterbildung der Erfindung die Fügeverbindung eine Pressschweißverbindung ist. Vorzugsweise kann die Pressschweißverbindung eine Ultraschallschweißverbindung sein.

Denkbar ist es beispielsweise, dass die Wellenkonturen des ersten und des zweiten Gehäuseteils in der Fügeverbindung und/oder beim Fügen lediglich einer Führung dienen. Hingegen ist es für eine besonders sichere Verbindung des ersten und des zweiten Gehäuseteils sowie für einen weiter erhöhten Manipulationsschutz von besonderem Vorteil, wenn gemäß einer Weiterbildung der Erfindung die Wellenkontur des ersten Gehäuseteils und die Wellenkontur des zweiten Gehäuseteils miteinander pressverschweißt, vorzugsweise ultraschallverschweißt, sind.

Gemäß einer anderen vorteilhaften Weiterbildung der Erfindung sind die Wellenkonturen des ersten Gehäuseteils und des zweiten Gehäuseteils jeweils unregelmäßig ausgebildet. Die unregelmäßige Ausbildung der Wellenkonturen bedeutet, dass diese zum Beispiel nicht sinuskurvenförmig ausgebildet sind. Von besonderem Vorteil ist es zudem, wenn in Querrichtung der Längsachse des Gerätegehäuses auf gegenüberliegenden Seiten der Längsachse angeordnete Wellenkonturabschnitte der Wellenkontur nicht deckungsgleich sind.

Gemäß einer vorteilhaften Weiterbildung der Erfindung weisen die Wellenkonturen jeweils untereinander verschiedene Wellenberghöhen auf. Mit einer solchen Ausgestaltung wird der Manipulationsschutz des Magnetfeldsensors vorteilhaft zusätzlich erhöht.

Gemäß einer anderen vorteilhaften Weiterbildung der Erfindung ist das erste Gehäuseteil und/oder das zweite Gehäuseteil jeweils ein Spritzgussbauteil, und eine Formtrennkante des jeweiligen Gehäuseteils folgt der Wellenkontur des jeweiligen Gehäuseteils. Somit ist an dem Gehäuseteil auch keine von der Wellenkontur abweichende, sichtbare Formtrennkante vorhanden, entlang welcher ggf. ein nur schwer zu entdeckendes Auftrennen des Gerätegehäuses in manipulativer Absicht erfolgen könnte.

Eine andere vorteilhafte Weiterbildung der Erfindung zeichnet sich dadurch aus, dass das erste Gehäuseteil und/oder das zweite Gehäuseteil eine Mehrzahl von parallel zu der Längsachse des Gerätegehäuses ausgerichteten Gehäusematerialschwächungen aufweist, wobei die Gehäusematerialschwächungen im Bereich der Fügeverbindung angeordnet sind. Somit sind nach dieser Weiterbildung der Erfindung mindestens zwei Gehäusematerialschwächungen an dem Gerätegehäuse vorhanden. Die Gehäusematerialschwächungen können zum Beispiel als Nuten in dem Gerätegehäuse ausgebildet sein. Dass die Gehäusematerialschwächungen im Bereich der Fügeverbindung angeordnet sind bedeutet, dass sich die Gehäusematerialschwächungen in der Fügeverbindung befinden oder angrenzend an die Fügeverbindung angeordnet sind. Die Gehäusematerialschwächungen wirken als Soll-Bruchstellen, sodass zum Beispiel ein Versuch, die Fügeverbindung durch Verdrehen der Gehäuseteile gegeneinander zu öffnen, zu einem Aufbrechen und somit Zerstören des Gerätegehäuses führt.

Einer anderen vorteilhaften Weiterbildung der Erfindung gemäß weist die Fügeverbindung einen parallel zu der Längsachse des Gerätegehäuses ausgerichteten Zapfen und eine den Zapfen aufnehmende korrespondierende Tasche auf, wobei der Zapfen an einem der beiden Gehäuseteile und die Tasche an dem anderen der beiden Gehäuseteile angeordnet ist. Damit ist, vorzugsweise im Inneren des Gerätegehäuses, vorteilhaft eine zusätzliche Verbindung zwischen den beiden Gehäuseteilen geschaffen. Der Zapfen, der auch als Schwert oder Dorn bezeichnet werden könnte, ist in Fügerichtung der Fügeverbindung ausgerichtet. Die Tasche kann zum Beispiel kastenförmig ausgebildet sein. Der Zapfen ist an dem ersten Gehäuseteil oder an dem zweiten Gehäuseteil und die Tasche umgekehrt an dem zweiten Gehäuseteil bzw. dem ersten Gehäuseteil angeordnet.

Es wäre zum Beispiel denkbar, dass Zapfen und Tasche nur zur Führung in der Fügeverbindung angeordnet sind. Hingegen ist es von besonderem Vorteil, wenn gemäß einer Weiterbildung der Erfindung der Zapfen und die Tasche miteinander pressverschweißt sind. Vorzugsweise sind der Zapfen und die Tasche miteinander ultraschallverschweißt. Aufgrund der Schweißverbindung von Zapfen und Tasche ist ein Auseinanderziehen oder Aufbrechen der Verbindung nahezu unmöglich.

Einer anderen vorteilhaften Weiterbildung der Erfindung entsprechend weist das Gehäuseteil, dem die Tasche zugeordnet ist, umlaufend um die Tasche eine Gehäusematerialschwächung auf. Die Gehäusematerialschwächung kann zum Beispiel eine Nut sein. Vorzugsweise ist die Gehäusematerialschwächung kerbenförmig ausgebildet. Die Gehäusematerialschwächung bildet eine Soll-Bruchstelle zwischen Tasche und Gehäuseteil.

Einer anderen vorteilhaften Weiterbildung der Erfindung gemäß weist das Gehäuseteil, dem der Zapfen zugeordnet ist, umlaufend um den Zapfen eine Gehäusematerialschwächung, die zum Beispiel als Nut ausgebildet sein kann, auf. Die Gehäusematerialschwächung ist vorzugsweise kerbenförmig ausgebildet. Die Gehäusematerialschwächung bildet eine Soll-Bruchstelle zwischen Zapfen und Gehäuseteil.

Ausführungsbeispiele der Erfindung sind in der Zeichnung skizzenhaft und schematisiert dargestellt und werden im Folgenden näher beschrieben. Es zeigen:
- Figur 1: ein Gerätegehäuse eines Magnetfeldsensors in einer perspektivischen Ansicht,
- Figur 2: einen Ausschnitt eines ersten Gehäuseteils des Gerätegehäuses nach Figur 1 in einer perspektivischen Ansicht,
- Figur 3: eine Seitenansicht eines Ausschnitts des ersten Gehäuseteils nach Figur 2,
- Figur 4: einen Ausschnitt des ersten Gehäuseteils nach Figur 2 in einer perspektivischen Ansicht,
- Figur 5: einen Ausschnitt des ersten Gehäuseteils nach Figur 2 in einer weiteren perspektivischen Ansicht,
- Figur 6: einen Ausschnitt des ersten Gehäuseteils nach Figur 2 in einer Schnittansicht,
- Figur 7: einen Ausschnitt des ersten Gehäuseteils nach Figur 2 in einer weiteren Schnittansicht,
- Figur 8: einen Ausschnitt des ersten Gehäuseteils nach Figur 2 in einer weiteren perspektivischen Ansicht,
- Figur 9: einen Ausschnitt des ersten Gehäuseteils nach Figur 2 in einer weiteren Schnittansicht,
- Figur 10: einen vergrößerten Ausschnitt A der Schnittansicht nach Figur 9 des ersten Gehäuseteils,
- Figur 11: ein zweites Gehäuseteil des Gerätegehäuses nach Figur 1 in einer perspektivischen Ansicht,
- Figur 12: das zweite Gehäuseteil nach Figur 11 in einer weiteren perspektivischen Ansicht,
- Figur 13: eine Schnittansicht des zweiten Gehäuseteils nach Figur 11,
- Figur 14: eine Schnittansicht eines Ausschnitts des Gerätegehäuses nach Figur 1,
- Figur 15: eine perspektivische Schnittansicht eines Ausschnitts des Gerätegehäuses nach Figur 1 und
- Figur 16: eine weitere perspektivische Schnittansicht eines Ausschnitts des Gerätegehäuses nach Figur 1.

Sich jeweils entsprechende Elemente sind in allen Figuren mit gleichen Bezugszeichen versehen.

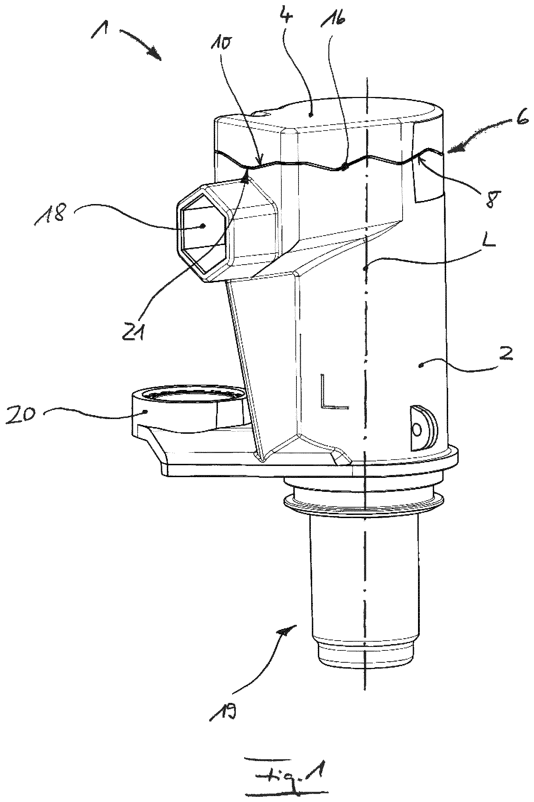

Figur 1 zeigt in einer perspektivischen Seitenansicht ein Gerätegehäuse 1 eines Magnetfeldsensors. Das Gerätegehäuse 1 weist ein erstes Gehäuseteil 2, das als Gehäusetopf ausgebildet ist, und ein das erste Gehäuseteil 2 verschließendes zweites Gehäuseteil 4, das als Gehäusedeckel ausgebildet ist, auf. In diesem Ausführungsbeispiel bilden das erste Gehäuseteil 2 und das zweite Gehäuseteil 4 gemeinsam das Gerätegehäuse 1.

Sowohl das erste Gehäuseteil 2 als auch das zweite Gehäuseteil 4 besteht in diesem Ausführungsbeispiel aus einem Kunststoffmaterial und ist vorzugsweise ein Kunststoffspritzgussbauteil. Dem Kunststoffmaterial des ersten Gehäuseteils 2 sowie des zweiten Gehäuseteils 4 können Glasfasern zur Festigkeitserhöhung beigefügt sein.

Das erste Gehäuseteil 2 und das zweite Gehäuseteil 4 sind in Richtung einer Längsachse L des Gerätegehäuses 1 gefügt und mittels einer nicht-lösbaren Fügeverbindung 6 verbunden. Das erste Gehäuseteil 2 und das zweite Gehäuseteil 4 weisen jeweils eine korrespondierende Wellenkontur 8, 10 auf. Die Wellenkontur 8 des ersten Gehäuseteils 2 ist passgenau zu der Wellenkontur 10 des zweiten Gehäuseteils 4 ausgebildet.

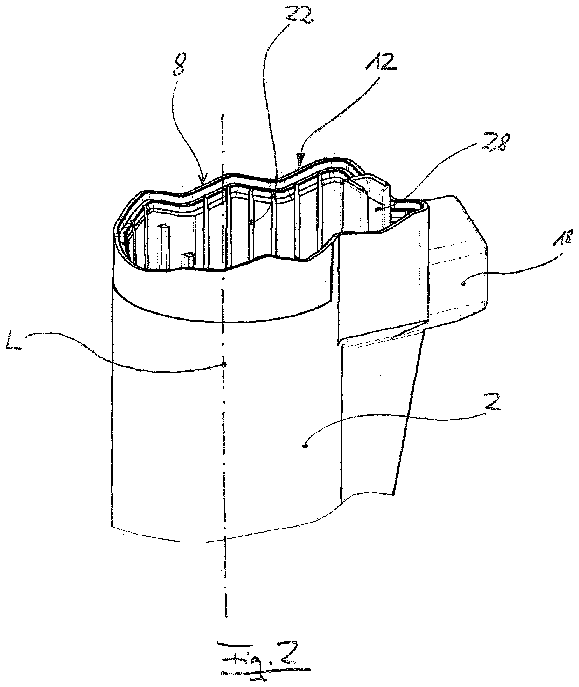

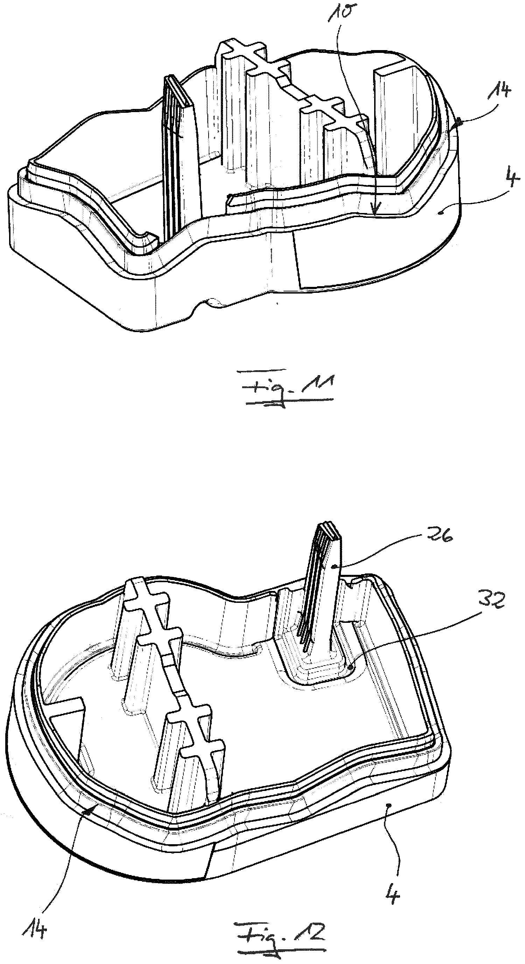

Die Wellenkonturen 8, 10 sind in Richtung der Längsachse L des Gerätegehäuses 1 ausgebildet. Zudem sind die Wellenkonturen 8, 10 an einem Gehäuserand 12 des ersten Gehäuseteils 2 (siehe Figur 2) bzw. an einem Gehäuserand 14 des zweiten Gehäuseteils 4 (siehe Figur 11) ausgebildet.

Beispielsweise aus Figur 2 wird besonders deutlich, dass die Wellenkontur 8 eine Struktur aufweist, die zum Beispiel als Kronenstruktur oder wellenförmiges Kronendesign bezeichnet werden kann. In der Fügeverbindung 6 bilden die Wellenkonturen 8, 10 eine Fügewellenkontur 16. Auch die Fügewellenkontur 16 bildet aufgrund der jeweils kronenstrukturförmigen Wellenkonturen 8, 10 eine Kronenstruktur.

Das Gerätegehäuse 1 des Magnetfeldsensors weist in diesem Ausführungsbeispiel zudem an dem ersten Gehäuseteil 2 einen Kabeleingang 18 zur elektrischen Verbindung von in dem Gerätegehäuse 1 angeordneten elektronischen Bauelementen des Magnetfeldsensors mit zum Beispiel einem Fahrtschreiber auf. Beispielsweise ist ein Verbindungskabel zu dem Fahrtschreiber durch den Kabeleingang 18 in das Gerätegehäuse 1 eingeführt und mit einer in dem Gerätegehäuse 1 angeordneten Leiterplatte elektrisch verbunden.

Die Leiterplatte trägt ein Sensorelement, zum Beispiel ein Hall-Element. Das Sensorelement und gegebenenfalls ein zugehöriger, an der Leiterplatte angeordneter Magnet ist in einem Sensorkopf 19 des Magnetfeldsensors, welcher Magnetfeldsensor auch als Induktivgeber bezeichnet werden kann, angeordnet. Ein Teil des ersten Gehäuseteils 2 des Gerätegehäuses 1, nämlich hier ein topfförmiger Endabschnitt des ersten Gehäuseteils 2, ist Bestandteil des Sensorkopfs 19. Weiterhin weist das erste Gehäuseteil 2 ein Anschlusselement 20 zur Befestigung des Magnetfeldsensors zum Beispiel an einem Kraftfahrzeug auf.

In dem hier gezeigten Ausführungsbeispiel ist die Fügeverbindung 6 eine Pressschweißverbindung. Sie kann in einem speziellen Ausführungsbeispiel insbesondere eine Ultraschallschweißverbindung sein. Die Wellenkontur 8 des ersten Gehäuseteils 2 und die Wellenkontur 10 des zweiten Gehäuseteils 4 sind miteinander pressverschweißt, insbesondere ultraschallverschweißt.

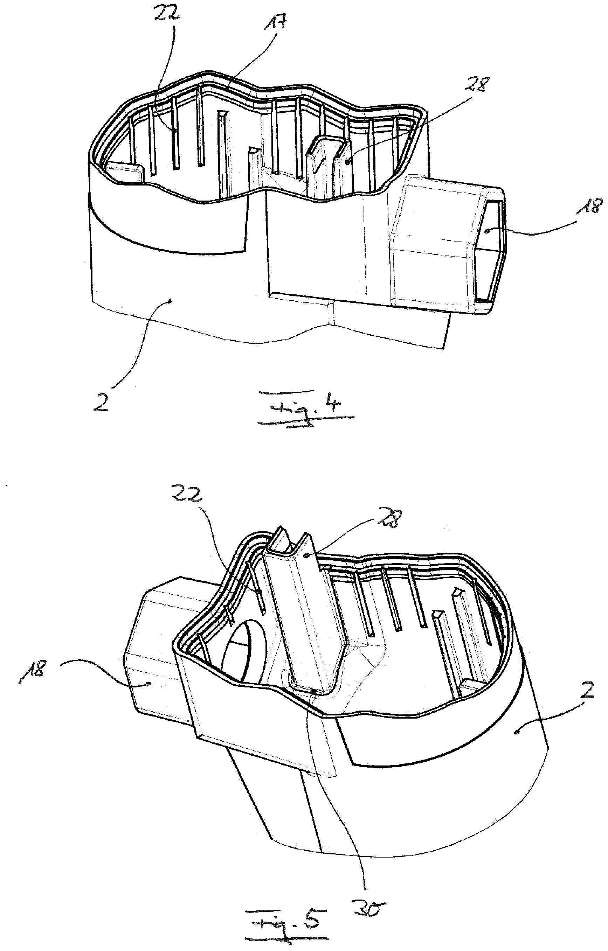

Zum Beispiel bildet hierfür an dem ersten Gehäuseteil 2 eine umlaufende Absatzfläche 17 (siehe Figur 4) eine Schweißfläche zur Verbindung mit dem zweiten Gehäuseteil 4. Die Fügewellenkontur 16 ist somit die resultierende Wellenkontur der Fügeverbindung 6 nach dem Verschweißen von erstem Gehäuseteil 2 und zweitem Gehäuseteil 4. Zum Beispiel mittels eines geraden Sägeschnittes aufgetrennt, lassen sich die beiden Teile, nämlich erstes Gehäuseteil 2 und zweites Gehäuseteil 4, nicht mehr erneut Fügen, ohne dass das vorherige Auftrennen weiterhin erkennbar bleibt, da sich der durch die Fügewellenkontur 16 führende Sägeschnitt nicht kaschieren lässt.

Denkbar ist es zum Beispiel auch, dass in einem anderen Ausführungsbeispiel die Fügeverbindung eine Klebeverbindung ist, und dass die Wellenkontur 8 des ersten Gehäuseteils 2 und die Wellenkontur 10 des zweiten Gehäuseteils 4 miteinander verklebt sind.

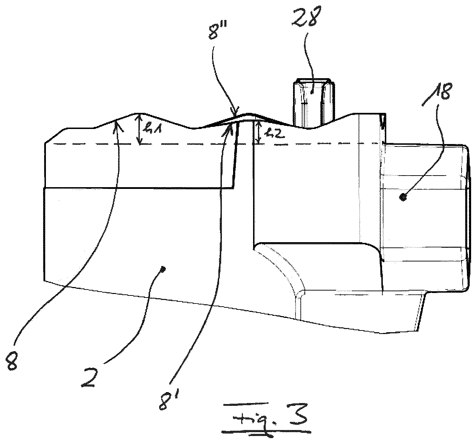

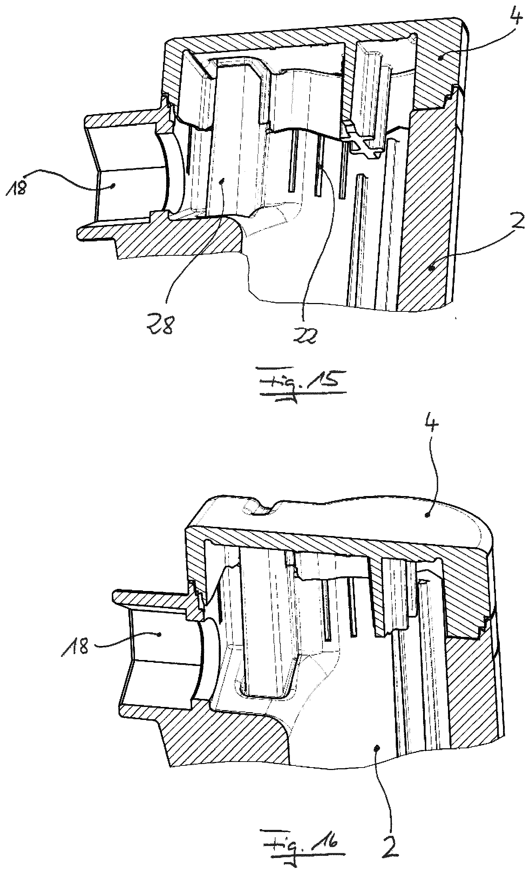

Aus Figuren 1 bis 8 und 11 bis 16 wird deutlich, dass die Wellenkonturen 8, 10 des ersten Gehäuseteils 2 und des zweiten Gehäuseteils 4 jeweils unregelmäßig ausgebildet sind. Zum Beispiel Figur 3 zeigt zudem deutlich, dass die Wellenkonturen, hier gezeigt anhand der Wellenkontur 8 des ersten Gehäuseteils 2, untereinander verschiedene Wellenberghöhen h1, h2 aufweisen.

Ferner sind, wie insbesondere aus der in Figur 3 gezeigten Seitenansicht ersichtlich ist, in Querrichtung der Längsachse L des Gerätegehäuses 1 auf gegenüberliegenden Seiten der Längsachse L angeordnete Wellenkonturabschnitte 8', 8" der Wellenkontur 8 nicht deckungsgleich. Außerdem befindet sich im Bereich des Kabeleingangs 18 an dem ersten Gehäuseteil 2 ein Wellental 21, welches keinerlei Überdeckung mit einem anderen Konturabschnitt zulässt (siehe zum Beispiel Figur 1).

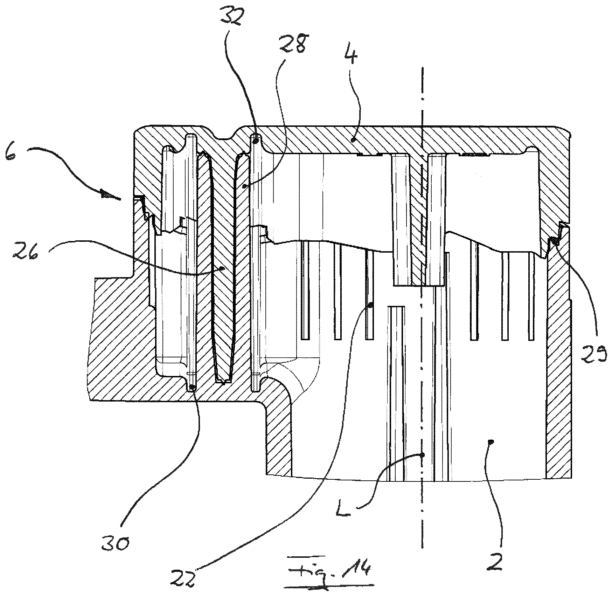

Das erste Gehäuseteil 2 weist eine Mehrzahl von parallel zu der Längsachse L des Gerätegehäuses 1 ausgerichteten Gehäusematerialschwächungen 22 auf (siehe zum Beispiel Figuren 2, 14). Die Gehäusematerialschwächungen 22 sind im Bereich der Fügeverbindung 6 angeordnet. Sie dienen als Soll-Bruchstellen zum Beispiel bei einem Versuch, das Gerätegehäuse 2 durch Verdrehen des ersten Gehäuseteils 2 und des zweiten Gehäuseteils 4 gegeneinander zu öffnen. In dem hier gezeigten Ausführungsbeispiel sind die Gehäusematerialschwächungen 22 nutförmig ausgebildet.

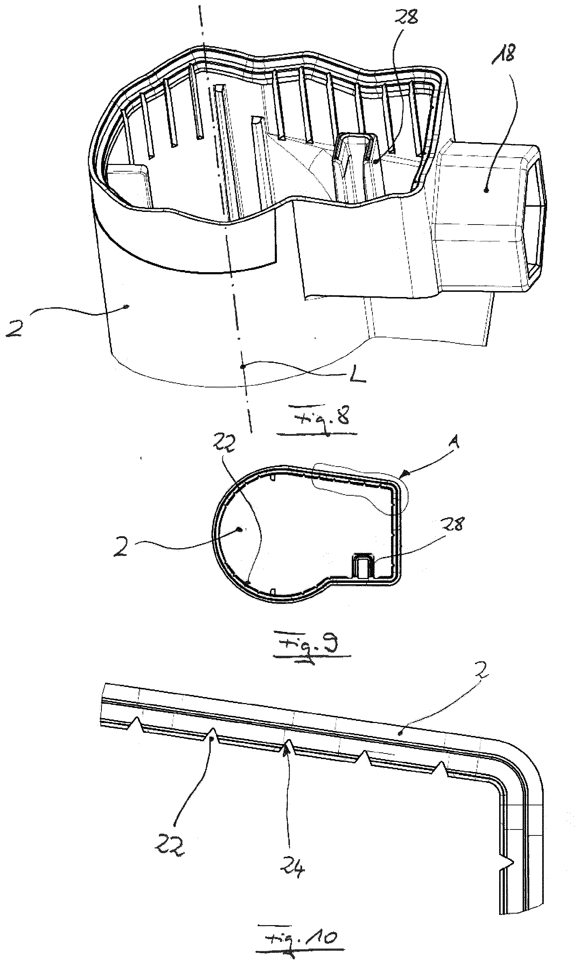

Figur 9 zeigt in einer Schnittansicht des ersten Gehäuseteils 2, dass die Gehäusematerialschwächungen 22 umlaufend an der Innenseite des ersten Gehäuseteils 2 angeordnet sind. In einem vergrößerten Ausschnitt A aus Figur 9 zeigt Figur 10 eine kerbenförmige Querschnittsausbildung 24 der Gehäusematerialschwächungen 22, das heißt die Gehäusematerialschwächungen 22 sind kerbenförmig ausgebildet.

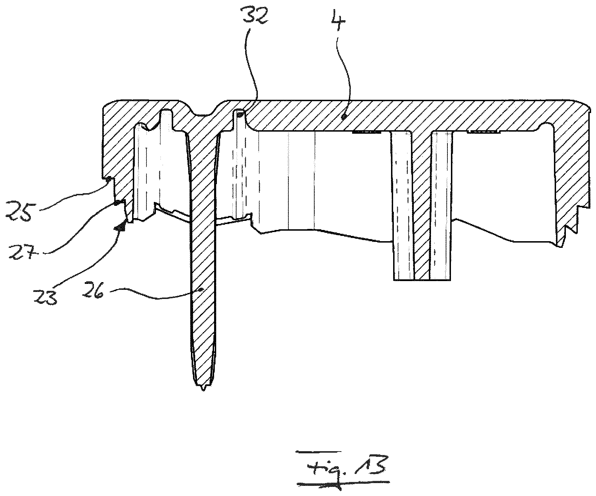

Das zweite Gehäuseteil 4 weist eine Fügekontur 23 (siehe Figur 13) zur Vormontage von zweitem Gehäuseteil 4 und erstem Gehäuseteil 2 auf. Eine außenliegende Anschlagfläche 25 des zweiten Gehäuseteils 4 dient als Anschlag für das erste Gehäuseteil 2 bei der Vormontage. Ein zwischen Fügekontur 23 und Anschlagfläche 25 angeordneter sogenannter Energierichtungsgeber 27 des zweiten Gehäuseteils 4 korrespondiert mit der Absatzfläche 17 des ersten Gehäuseteils 2. Der Energierichtungsgeber 27 bildet einen Bereich des zweiten Gehäuseteils 4, welcher Bereich mit der Absatzfläche 17 des ersten Gehäuseteils 2 beim Ultraschallverschweißen von erstem Gehäuseteil 2 und zweitem Gehäuseteil 4 verschweißt wird. Nach dem Verschweißen liegt ein um das Gerätegehäuse 1 umlaufender Verschweißungsbereich 29 vor, der sowohl Bestandteil des ersten Gehäuseteils 2 als auch des zweiten Gehäuseteils 4 ist (siehe Figur 14).

Zum Beispiel in Figur 14 ist dargestellt, dass die Fügeverbindung 6 einen parallel zu der Längsachse L des Gerätegehäuses 1 ausgerichteten Zapfen 26 und eine den Zapfen 26 aufnehmende korrespondierende Tasche 28 aufweist. Dabei ist der Zapfen 26 an dem zweiten Gehäuseteil 4 und die Tasche 28 an dem ersten Gehäuseteil 2 angeordnet. Der Zapfen 26 und die Tasche 28 sind in diesem Ausführungsbeispiel miteinander pressverschweißt, insbesondere ultraschallverschweißt. Der Zapfen 26 ist schwertförmig und die Tasche 28 kastenförmig ausgebildet.

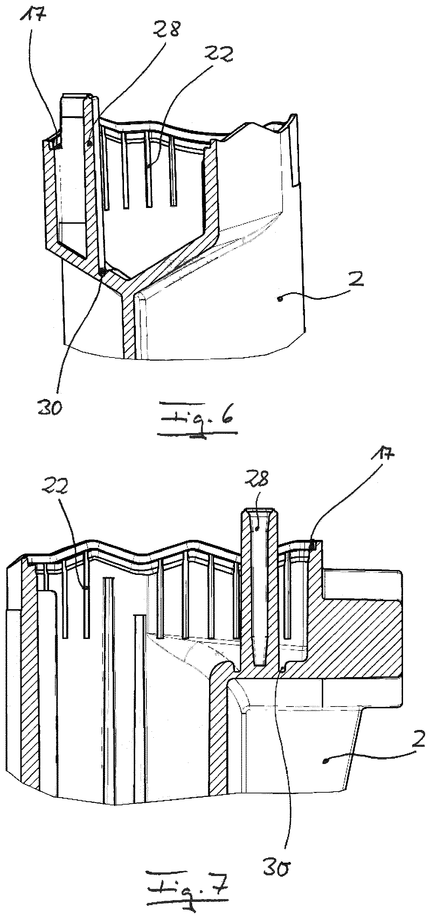

Das Gehäuseteil, nämlich hier das erste Gehäuseteil 2, dem die Tasche 28 zugeordnet ist, weist umlaufend um die Tasche 28 eine Gehäusematerialschwächung 30 auf (siehe zum Beispiel Figur 7). Diese Gehäusematerialschwächung 30, die in diesem Ausführungsbeispiel nutförmig ausgebildet ist, dient als zusätzliche Soll-Bruchstelle zum Beispiel bei einem Versuch, das Gerätegehäuse 1 gewaltsam zu öffnen. Die Gehäusematerialschwächung 30 ist vorzugsweise kerbenförmig ausgebildet.

Weiterhin weist das Gehäuseteil, nämlich hier das zweite Gehäuseteil 4, dem der Zapfen 26 zugeordnet ist, umlaufend um den Zapfen 26 eine Gehäusematerialschwächung 32 auf (siehe zum Beispiel Figur 13). In dem hier gezeigten Ausführungsbeispiel ist diese Gehäusematerialschwächung 32 an dem zweiten Gehäuseteil 4 eine Nut. Vorzugsweise ist sie kerbenförmig ausgebildet.

Im Falle eines Versuchs, beispielsweise mittels Walkens oder Aufhebelns die Schweißverbindung zwischen Zapfen 26 und Tasche 28 zu schwächen und zu zerstören, platzen oder reißen oder brechen die um den Zapfen 26 umlaufende Gehäusematerialschwächung 32 an dem zweiten Gehäuseteil 4 und/oder die um die Tasche 28 umlaufende Gehäusematerialschwächung 30 an dem ersten Gehäuseteil 2 auf. Damit wird ein solcher Manipulationsversuch an dem Magnetfeldsensor eindeutig sichtbar. Entsprechendes gilt auch für ein Aufplatzen oder Aufreißen oder Aufbrechen der oben beschriebenen, parallel zu der Längsachse L des Gerätegehäuses 1 ausgerichteten und im Bereich der Fügeverbindung 6 angeordneten Gehäusematerialschwächungen 22.

Vorzugsweise bricht das Kunststoffmaterial des ersten Gehäuseteils 2 und des zweiten Gehäuseteils 4 glasartig. Weiter vorzugsweise weist das Kunststoffmaterial im Zerstörungsbereich, in dem es aufplatzt oder aufreißt oder aufbricht, eine erkennbare, sich durch die Zerstörung ergebende Verfärbung auf.

Mit der Erfindung kann vorteilhaft das Ziel erreicht werden, ein nicht-sichtbares Öffnen des Gerätegehäuses 1 zu verhindern. Die eine Kronenstruktur bildende Fügewellenkontur 16 lässt es nicht zu, mit einem ebenen und schmalen (Säge-)Schnitt das erste Gehäuseteil 2 von dem zweiten Gehäuseteil 4 derart zu trennen, dass ein solcher Schnitt bei einem späteren erneuten Fügen von erstem Gehäuseteil 2 und zweitem Gehäuseteil 4 unerkennbar wird. Ein Manipulationsversuch durch Öffnen des Magnetfeldsensors ist dadurch optisch einfach zu detektieren.

## Patentansprüche

1. Magnetfeldsensor mit einem zumindest ein erstes Gehäuseteil (2) und ein das erste Gehäuseteil (2) verschließendes zweites Gehäuseteil (4) aufweisenden Gerätegehäuse (1), 1
**dadurch gekennzeichnet, dass** das erste Gehäuseteil (2) und das zweite Gehäuseteil (4) in Richtung einer Längsachse (L) des Gerätegehäuses (1) gefügt und mittels einer nicht-lösbaren Fügeverbindung (6) verbunden sind, wobei das erste Gehäuseteil (2) und das zweite Gehäuseteil (4) jeweils eine korrespondierende Wellenkontur (8, 10) aufweisen, wobei die Wellenkonturen (8, 10) in Richtung der Längsachse (L) des Gerätegehäuses (1) und an einem Gehäuserand (12) des ersten Gehäuseteils (2) bzw. an einem Gehäuserand (14) des zweiten Gehäuseteils (4) ausgebildet sind und in der Fügeverbindung (6) eine Fügewellenkontur (16) bilden, wobei die Fügewellenkontur (16) an einer Außenseite des Gerätegehäuses (1) um das Gerätegehäuse (1) umläuft und wobei die Wellenkontur (8) an dem ersten Gehäuseteil (2) und die Wellenkontur (10) an dem zweiten Gehäuseteil (4) jeweils eine Kronenstruktur an dem jeweiligen Gehäuseteil (2, 4) bilden, wobei entsprechend auch die Fügewellenkontur (16) eine Kronenstruktur bildet.

2. Magnetfeldsensor nach Anspruch 1, **dadurch gekennzeichnet, dass** die Fügeverbindung (6) eine Pressschweißverbindung ist.

3. Magnetfeldsensor nach Anspruch 1 oder 2, **dadurch gekennzeichnet, dass** die Wellenkontur (8) des ersten Gehäuseteils (2) und die Wellenkontur (10) des zweiten Gehäuseteils (4) miteinander pressverschweißt sind.

4. Magnetfeldsensor nach einem der vorhergehenden Ansprüche, **dadurch gekennzeichnet, dass** die Wellenkonturen (8, 10) des ersten Gehäuseteils (2) und des zweiten Gehäuseteils (4) jeweils unregelmäßig ausgebildet sind.

5. Magnetfeldsensor nach Anspruch 4, **dadurch gekennzeichnet, dass** die Wellenkonturen (8, 10) jeweils untereinander verschiedene Wellenberghöhen (h1, h2) aufweisen.

6. Magnetfeldsensor nach einem der vorhergehenden Ansprüche, **dadurch gekennzeichnet, dass** das erste Gehäuseteil (2) und/oder das zweite Gehäuseteil (4) jeweils ein Spritzgussbauteil ist und dass eine Formtrennkante des jeweiligen Gehäuseteils (2, 4) der Wellenkontur (8, 10) des jeweiligen Gehäuseteils (2, 4) folgt.

7. Magnetfeldsensor nach einem der vorhergehenden Ansprüche, **dadurch gekennzeichnet, dass** das erste Gehäuseteil (2) und/oder das zweite Gehäuseteil (4) eine Mehrzahl von parallel zu der Längsachse (L) des Gerätegehäuses (1) ausgerichteten Gehäusematerialschwächungen (22) aufweist, wobei die Gehäusematerialschwächungen (22) im Bereich der Fügeverbindung (6) angeordnet sind.

8. Magnetfeldsensor nach einem der vorhergehenden Ansprüche, **dadurch gekennzeichnet, dass** die Fügeverbindung (6) einen parallel zu der Längsachse (L) des Gerätegehäuses (1) ausgerichteten Zapfen (26) und eine den Zapfen (26) aufnehmende korrespondierende Tasche (28) aufweist, wobei der Zapfen (26) an einem der beiden Gehäuseteile (4) und die Tasche (28) an dem anderen der beiden Gehäuseteile (2) angeordnet ist.

9. Magnetfeldsensor nach Anspruch 8, **dadurch gekennzeichnet, dass** der Zapfen (26) und die Tasche (28) miteinander pressverschweißt sind.

10. Magnetfeldsensor nach Anspruch 8 oder 9, **dadurch gekennzeichnet, dass** das Gehäuseteil (2), dem die Tasche (28) zugeordnet ist, umlaufend um die Tasche (28) eine Gehäusematerialschwächung (30) aufweist.

11. Magnetfeldsensor nach einem der Ansprüche 8 bis 10, **dadurch gekennzeichnet, dass** das Gehäuseteil (4), dem der Zapfen (26) zugeordnet ist, umlaufend um den Zapfen (26) eine Gehäusematerialschwächung (32) aufweist.

## Claims

1. Magnetic field sensor having a device housing (1) which has at least a first housing part (2) and a second housing part (4) closing the first housing part (2), **characterized in that** the first housing part (2) and the second housing part (4) are joined in the direction of a longitudinal axis (L) of the device housing (1) and connected by means of a nonreleasable jointed connection (6), wherein the first housing part (2) and the second housing part (4) each have a corresponding corrugation contour (8, 10), wherein the corrugation contours (8, 10) are formed in the direction of the longitudinal axis (L) of the device housing (1) and on a housing edge (12) of the first housing part (2) and on a housing edge (14) of the second housing part (4), respectively, and form a jointed corrugation contour (16) in the jointed connection (6), wherein the jointed corrugation contour (16) runs around the device housing (1) on an outer side of the device housing (1), and wherein the corrugation contour (8) on the first housing part (2) and the corrugation contour (10) on the second housing part (4) each form a crown structure on the respective housing part (2, 4), wherein, correspondingly, the jointed corrugation contour (16) also forms a crown structure.

2. Magnetic field sensor according to Claim 1, **characterized in that** the jointed connection (6) is a pressure-welding connection.

3. Magnetic field sensor according to Claim 1 or 2, **characterized in that** the corrugation contour (8) of the first housing part (2) and the corrugation contour (10) of the second housing part (4) are pressure-welded to one another.

4. Magnetic field sensor according to one of the preceding claims, **characterized in that** the corrugation contours (8, 10) of the first housing part (2) and of the second housing part (4) each have an irregular design.

5. Magnetic field sensor according to Claim 4, **characterized in that** the corrugation contours (8, 10) each have mutually different corrugation crest heights (h1, h2).

6. Magnetic field sensor according to one of the preceding claims, **characterized in that** the first housing part (2) and/or the second housing part (4) are/is respectively an injection-moulded component, and **in that** a mould parting edge of the respective housing part (2, 4) follows the corrugation contour (8, 10) of the respective housing part (2, 4).

7. Magnetic field sensor according to one of the preceding claims, **characterized in that** the first housing part (2) and/or the second housing part (4) have/has a plurality of housing material weakenings (22) oriented parallel to the longitudinal axis (L) of the device housing (1), wherein the housing material weakenings (22) are arranged in the region of the jointed connection (6).

8. Magnetic field sensor according to one of the preceding claims, **characterized in that** the jointed connection (6) has a post (26) oriented parallel to the longitudinal axis (L) of the device housing (1) and a corresponding pocket (28) receiving the post (26), wherein the post (26) is arranged on one of the two housing parts (4) and the pocket (28) is arranged on the other of the two housing parts (2).

9. Magnetic field sensor according to Claim 8, **characterized in that** the post (26) and the pocket (28) are pressure-welded to one another.

10. Magnetic field sensor according to Claim 8 or 9, **characterized in that** the housing part (2) to which the pocket (28) is assigned has a housing material weakening (30) running around the pocket (28).

11. Magnetic field sensor according to one of Claims 8 to 10, **characterized in that** the housing part (4) to which the post (26) is assigned has a housing material weakening (32) running around the post (26).

## Revendications

1. Capteur de champ magnétique avec un boîtier d'appareil (1) présentant au moins une première partie de boîtier (2) et une deuxième partie de boîtier (4) fermant la première partie de boîtier (2),
**caractérisé en ce que** la première partie de boîtier (2) et la deuxième partie de boîtier (4) sont assemblées dans la direction d'un axe longitudinal (L) du boîtier d'appareil (1) et sont reliées au moyen d'une liaison d'assemblage (6) non détachable, la première partie de boîtier (2) et la deuxième partie de boîtier (4) présentant chacune un contour ondulé (8, 10) correspondant, les contours ondulés (8, 10) étant réalisés dans la direction de l'axe longitudinal (L) du boîtier d'appareil (1) et sur un bord de boîtier (12) de la première partie de boîtier (2) ou sur un bord de boîtier (14) de la deuxième partie de boîtier (4) et formant un contour ondulé d'assemblage (16) dans la liaison d'assemblage (6), le contour ondulé d'assemblage (16) s'étendant sur un côté extérieur du boîtier d'appareil (1) autour du boîtier d'appareil (1) et le contour ondulé (8) sur la première partie de boîtier (2) et le contour ondulé (10) sur la deuxième partie de boîtier (4) formant respectivement une structure de couronne sur la partie de boîtier respective (2, 4), le contour ondulé d'assemblage (16) formant également de manière correspondante une structure de couronne.

2. Capteur de champ magnétique selon la revendication 1, **caractérisé en ce que** la liaison d'assemblage (6) est une liaison soudée sous pression.

3. Capteur de champ magnétique selon la revendication 1 ou 2, **caractérisé en ce que** le contour ondulé (8) de la première partie de boîtier (2) et le contour ondulé (10) de la deuxième partie de boîtier (4) sont soudés l'un à l'autre sous pression.

4. Capteur de champ magnétique selon l'une quelconque des revendications précédentes, **caractérisé en ce que** les contours ondulés (8, 10) de la première partie de boîtier (2) et de la deuxième partie de boîtier (4) sont respectivement réalisés sous forme irrégulière.

5. Capteur de champ magnétique selon la revendication 4, **caractérisé en ce que** les contours ondulés (8, 10) présentent respectivement des hauteurs de crête d'onde (h1, h2) différentes entre elles.

6. Capteur de champ magnétique selon l'une quelconque des revendications précédentes, **caractérisé en ce que** la première partie de boîtier (2) et/ou la deuxième partie de boîtier (4) est respectivement un composant moulé par injection et **en ce qu'**une arête de séparation de moule de la partie de boîtier respective (2, 4) suit le contour ondulé (8, 10) de la partie de boîtier respective (2, 4).

7. Capteur de champ magnétique selon l'une quelconque des revendications précédentes, **caractérisé en ce que** la première partie de boîtier (2) et/ou la deuxième partie de boîtier (4) présentent une pluralité d'affaiblissements de matériau de boîtier (22) orientés parallèlement à l'axe longitudinal (L) du boîtier d'appareil (1), les affaiblissements de matériau de boîtier (22) étant agencés dans la zone de liaison d'assemblage (6).

8. Capteur de champ magnétique selon l'une quelconque des revendications précédentes, **caractérisé en ce que** la liaison d'assemblage (6) présente un tenon (26) orienté parallèlement à l'axe longitudinal (L) du boîtier d'appareil (1) et une poche (28) correspondante recevant le tenon (26), le tenon (26) étant agencé sur l'une des deux parties de boîtier (4) et la poche (28) sur l'autre des deux parties de boîtier (2).

9. Capteur de champ magnétique selon la revendication 8, **caractérisé en ce que** le tenon (26) et la poche (28) sont soudés sous pression l'un à l'autre.

10. Capteur de champ magnétique selon la revendication 8 ou 9, **caractérisé en ce que** la partie de boîtier (2) à laquelle la poche (28) est associée présente un affaiblissement de matériau de boîtier (30) de manière circonférentielle autour de la poche (28).

11. Capteur de champ magnétique selon l'une quelconque des revendications 8 à 10, **caractérisé en ce que** la partie de boîtier (4) à laquelle le tenon (26) est associé présente un affaiblissement de matériau de boîtier (32) de manière circonférentielle autour du tenon (26).
